(19) **Europäisches Patentamt**

**European Patent Office**

**Office européen des brevets**

(11) Veröffentlichungsnummer: **0 618 757 A1**

(12) **EUROPÄISCHE PATENTANMELDUNG**

(21) Anmeldenummer: **94105177.3**

(51) Int. Cl.⁵: **H05K 3/34**

(22) Anmeldetag: **31.03.94**

(30) Priorität: **02.04.93 DE 4310930**

(43) Veröffentlichungstag der Anmeldung:
**05.10.94 Patentblatt 94/40**

(84) Benannte Vertragsstaaten:
**AT CH DE FR GB IT LI**

(71) Anmelder: **SIEMENS AKTIENGESELLSCHAFT**
**Wittelsbacherplatz 2**
**D-80333 München (DE)**

(72) Erfinder: **Hofmann, Kerstin**
**Pfälzer-Wald Strasse, 67**
**D-81539 München (DE)**

(54) Leiterplattenanordnung und Verfahren zur Herstellung einer Leiterplatte.

㊼ Bei einer Leiterplattenanordnung mit leitfähigen Verbindungsbereichen (2) für leitfähige Anschlußbereiche (Pads) (3, 8) und Lotresistbereichen (4), die höher sind als die Verbindungsbereiche und die Anschlußbereiche und die im Bereich der Anschlußflächen Aussparungen (5) aufweisen, ist vorgesehen, daß die Fläche einer Aussparung des Lotresists in Abhängigkeit von der Fläche eines Anschlußbereichs und einer gegebenen Lotkegelhöhe gewählt ist und daß in der Aussparung die Anschlußfläche (3, 8) breiter ist als der zugeordnete angeschlossene Verbindungsbereich (2, 9). Bei dem Verfahren zur Herstellung einer Leiterplatte ist vorgesehen, in die sich nach dem Verfahren ergebende Aussparung des Lotresists Lotmaterial aufzutragen, das die Anschlußfläche und ihre nicht leitfähige Umgebung in der Aussparung zumindest teilweise abdeckt. Der der Anschlußfläche zugeordnete Anschluß eines Bauelements wird durch Aufschmelzen des Lotmaterials mit der Anschlußfläche verlötet.

Fig. 7a

Fig. 7b

Die Erfindung betrifft eine Leiterplattenanordnung nach dem Oberbegriff des Patentanspruchs 1 und ein Verfahren zur Herstellung einer Leiterplatte nach den Oberbegriffen der Patentansprüche 8 bzw. 10.

Leiterplatten, die auf einem Substrat angeordnete Leiterbahnen und Anschlußflächen für zu bestückende Bauelemente aufweisen, haben meist langgestreckte, typischerweise einheitlich breite Anschlußflächen (Pads), die in ausreichender Entfernung von den Anschlußbereichen in schmalere Leiterbahnen übergehen. Das Leiterplattensubstrat besteht üblicherweise aus einem Isolator, während Leiterbahnen und Anschlußflächen aus einem gut leitfähigen Material, typischerweise Kupfer bestehen und verzinnt sein können.

Bei einem häufig angewandten Bestückungsverfahren für oberflächenmontierbare Bauelemente (SMD-Bauelemente) wird mit Hilfe eines Siebdruck-, eines Schablonendruck- oder eines Dosierverfahrens Lotpaste auf die Anschlußbereiche aufgebracht, die flächenförmige Lotdepots bildet. Auf die Lotpaste, die normalerweise Lotkugeln mit Durchmessern unter 50 $\mu$m enthält, werden die Anschlüsse des zu verlötenden Bauelements aufgebracht. Anschließend wird die Lotpaste im Reflowofen relativ langsam bis über den Schmelzpunkt der jeweiligen Lotlegierung erwärmt und so durch Aufschmelzen der Lotpaste die Lötverbindung hergestellt.

Mit abnehmendem Anschlußraster der Bauelemente werden die Toleranzen für eine zuverlässige Bestückung und Verlötung zunehmend geringer. Die Toleranzen betreffen die Anschlußflächenbreite und den Abstand benachbarter Anschlußflächen, die Genauigkeit des Lotpastenauftrags sowohl in lateraler als auch in vertikaler Richtung und die zulässige Durchbiegung der Leiterplatte unter der Voraussetzung, daß auch die Anschlüsse des zu verlötenden Bauelements, z. B. die bekannten Gullwing-Anschlüsse, hinsichtlich ihres Abstands vom Bauelementgehäuse einen Toleranzbereich haben. Zum Beispiel kann der Fehler auftauchen, daß bei einer Leiterplattendurchbiegung und/oder einem von der Leiterplatte weggebogenen, aber noch im Toleranzbereich liegenden Bauelementanschluß kein mechanischer Kontakt zwischen der Lotpaste und dem Bauelementanschluß besteht. Beim Aufschmelzen der Lotpaste kommt dann keine Lötverbindung zwischen dem Pad und dem Bauelementanschluß zustande. Ähnliche Probleme können auftauchen, wenn die Lotpaste beim Drucken versetzt gegen die Anschlußflächen aufgetragen wird. Andererseits können Bauelementanschlüsse, die beim Bestücken in die Lotpaste gedrückt werden, letztere seitlich herausquetschen, so daß beim nachfolgenden Reflowprozeß die einander zugeordnete herausgequetschte Lotpaste zweier benachbarter Anschlußflächen miteinander in Kontakt kommen und einen Kurzschluß zwischen den Anschlußflächen bilden kann.

Aus der US-A-5,024,372 ist ein Verfahren bekannt, bei dem zwischen die Anschlußflächen ein Lotresist, z. B. eine Lötstopfolie oder ein Lötstoplack aufgetragen wird, der höher als die Anschlußflächen bzw. die zu den Anschlußflächen hinführenden leitfähigen Verbindungsbereiche, d. h. die Leiterbahnen ist. Das Lotresist reicht dabei sehr nahe an die Anschlußfläche heran. In die durch das Lotresist entstehende Aussparung wird Lotpaste aufgetragen und anschließend unter Bildung eines massiven Lotdepots aufgeschmolzen. Anschließend erfolgt die Bestückung mit Bauelementen. Das Verfahren verhindert die Bildung von Kurzschlüssen zwischen benachbarten Anschlußflächen, kann jedoch die anderen oben beschriebenen Probleme nicht sicher verhindern.

Aus der US-A-5,172,853 ist eine Leiterplattenanordnung bekannt, bei der ebenfalls zwischen Anschlußflächen ein Lotresist vorgesehen ist, das im engen Abstand die Anschlußfläche umgibt und diese geringfügig überragt. In die entstehende Aussparung wird Lotpaste gefüllt, die anschließend aufgeschmolzen und eingeebnet wird, so daß die Oberfläche des sich ergebenden massiven Lotdepots und die Oberfläche des Lotresists etwa gleich hoch sind. Nach dem Aufbringen des Bauelements dehnt sich das Lotdepot bei dem Reflowprozeß in Richtung von der Leiterplatte weg aus, da es eine kugelförmige Gestalt annehmen möchte und gewährleistet somit eine zuverlässigere Lötung. Jedoch bereitet auch dieses Verfahren beim Übergang zu geringeren Anschlußrastern der Bauelemente zunehmende Probleme insbesonere hinsichtlich der Lötsicherheit.

Mit großem technischen Aufwand, d. h. sehr engen Bauelement- und Leiterplattentoleranzen, hochpräzisen Lotpastenschablonen, speziellen Lötpasten, sehr genauem Lotpastenauftrag, optimaler Justierung und ähnlichen Maßnahmen ist es bisher möglich, bei der Lotpastentechnik ein Rastermaß von 0,4 mm zu erreichen. Mit der zuvor beschriebenen Technik unter Verwendung massiver Lotdepots steigt der Aufwand mit abnehmendem Rastermaß ebenfalls jedoch überproportional.

Der Erfindung liegt die Aufgabe zugrunde, eine Möglichkeit zur Verringerung der oben beschriebenen Probleme anzugeben.

Diese Aufgabe wird bei einer Leiterplattenanordnung mit den Merkmalen des Anspruchs 1 und bei einem Verfahren zur Herstellung einer Leiterplatte durch die Merkmale der Ansprüche 8 und 10 gelöst.

Die Erfindung hat den Vorteil, daß die Lötpaste im einfachsten Fall direkt auf die Leiterplatte aufgebracht und mit einem Rakel in die Aussperrungen verteilt werden kann, ohne daß die angestrebte Qualität beim nachfolgenden Lötvorgang leidet.

EP 0 618 757 A1

Die Erfindung hat den weiteren Vorteil, daß aufgrund der geometrischen Verhältnisse des leitfähigen Anschlußbereichs und der von ihm fortführenden leitfähigen Verbindungsbereiche in Verbindung mit der in dem Lotresist vorgesehenen Aussparung ein Lotpastenauftrag auch außerhalb der leitfähigen Anschlußfläche in der Aussparung bzw. über dem leitfähigen Verbindungsbereich möglich ist. Beim nachfolgenden Reflowprozeß zieht sich die Lotpaste auf der breitesten Fläche, d. h. dem Anschlußbereich zu einer möglichst kugelförmigen Gestalt zusammen. Durch die Geometrie des Anschlußbereichs kann die Lotpaste zu dem vorgegebenen Ort, d. h. der Anschlußfläche quasi hingeführt und die Steighöhe des Lots so bemessen werden, daß sie dort am größten ist. Weiterhin hat die Erfindung den Vorteil, daß die aufgeschmolzene Lotpaste, d. h. das Lot von der Anschlußfläche bzw. einem Teil der Verbindungsbereiche vollständig aufgenommen werden kann, so daß ein Abreißen der Lotpaste vom übrigen Lot nicht auftreten kann. In jedem Fall ist eine Bildung von Kurzschlußbrücken zwischen benachbarten Anschlußbereichen nicht möglich.

Die Erfindung bietet somit den Vorteil, daß sich bei geringen Rastermaßen eine zuverlässige Lötverbindung ohne großen technischen Aufwand ergibt.

Ausgestaltungen in der Erfindung sind in Unteransprüchen gekennzeichnet.

Die Erfindung wird nachfolgend anhand von Ausführungsbeispielen näher beschrieben. Es zeigen:

Fig. 1    eine Draufsicht und einen Querschnitt durch einen Anschlußbereich vor und nach dem Aufschmelzen der Lotpaste,

Fig. 2    den Lotpastenauftrag und eine Bauelementbestückung für eine Leiterplattenanordnung,

Fig. 3    eine Bauelementbestückung mit nachfolgendem Lotpastenauftrag bei einer Leiterplattenanordnung,

Fig. 4    Querschnitte durch eine Leiterplattenanordnung zur Herstellung massiver Lotdepots,

Fig. 5    einen Querschnitt durch eine Leiterplattenanordnung mit massivem Lotdepot und Bauelementanschluß,

Fig. 6    eine Draufsicht und Querschnitte für die Bestückung einer Leiterplatte mit bedrahteten Bauelementanschlüssen,

Fig. 7    einen Querschnitt durch eine Leiterplattenanordnung zur Erläuterung der Ermittlung der Aussparung in dem Lotresist und

Fig. 8    eine Draufsicht auf einen Anschluß- und Verbindungsbereich mit Lotresistaussparung.

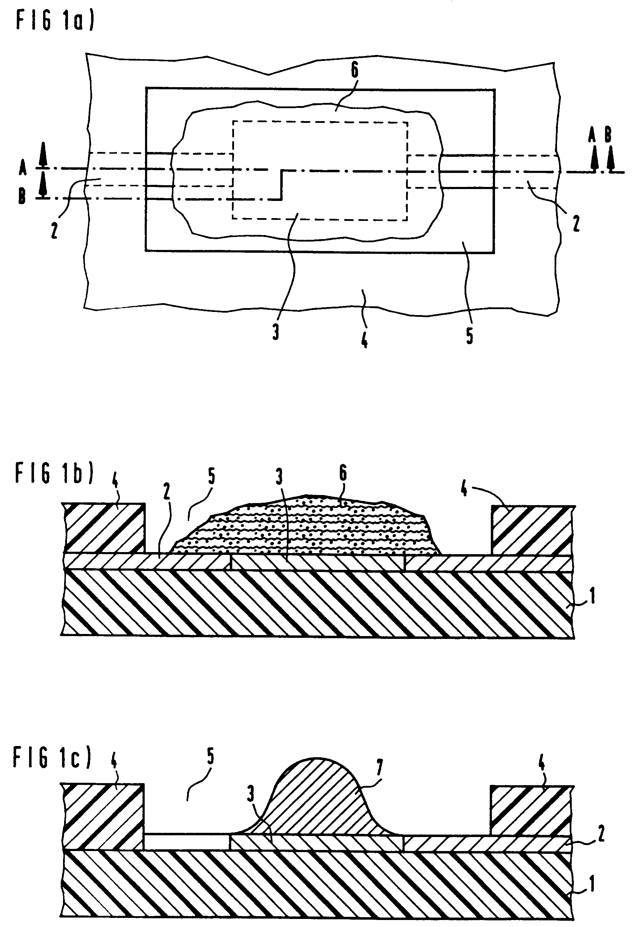

Fig. 1a) und b) zeigen eine Leiterplattenanordnung mit aufgetragener Lotpaste in der Draufsicht und im Schnitt entlang A-A. Auf ein Leiterplattensubstrat 1 sind leitfähige Verbindungsbereiche 2, z. B. Leiterverbindungen für einen leitfähigen Anschlußbereich, bzw. eine Anschlußfläche 3 vorgesehen. Weiterhin wird die Oberfläche der Leiterplatte bzw. der leitfähigen Verbindungsbereiche von einem Lotresist 4 abgedeckt, das im Bereich der Anschlußflächen Aussparungen 5 aufweist. Als Lotresist kommt eine Lötstopfolie bzw. ein Lötstoplack infrage. Das Lötresist ragt von der Leiterplatte aus höher über die leitfähigen Verbindungsbereiche und den Anschlußbereich der Anschlußfläche hinau, ist also dicker als diese Bereiche.

Bei der Leiterplattenanordnung ist vorgesehen, daß die Fläche einer Aussparung 5 des Lotresists in einer bestimmten Weise ermittelt ist und etwa doppelt so groß oder größer ist als die Fläche einer Anschlußfläche 3 und daß die Anschlußfläche in der Aussparung 5 breiter ist als der zugeordnete angeschlossene Verbindungsbereich 2. In Fig. 1a) ist dabei die Anschlußfläche 3 rechteckförmig und breiter als der zugeordnete anschließende stegförmige bzw. streifenleiterförmige Verbindungsbereich 2, der beidseitig von der Anschlußfläche 3 wegführt. Es ist jedoch auch ein einseitiger Anschluß oder eine andere Form der Anschlußfläche möglich.

In einer anderen Ausführungsform gemäß Fig. 3a) ist in der Aussparung 5 die Anschlußfläche 8 trapezförmig ausgebilde, und der zugeordnete Verbindungsbereich 9 schließt sich an die Anschlußfläche im wesentlichen ohne Abstufung an und geht dann in einen stegförmigen oder streifenleiterförmigen Verbindungsbereich 2 über.

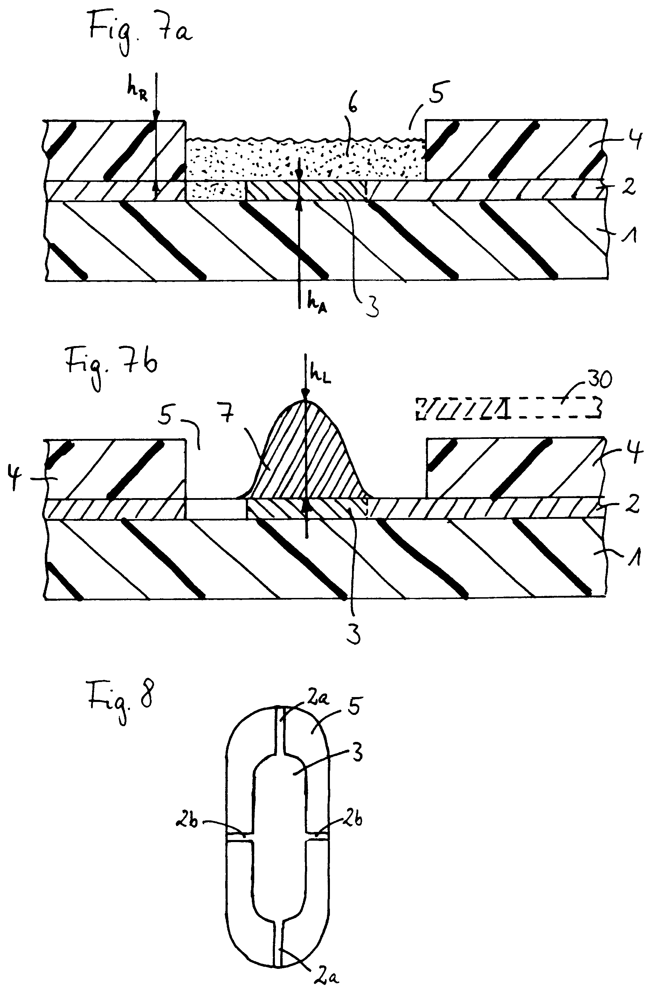

Wesentlich für die Erfindung ist, daß im Vergleich zur Anschlußfläche 3 die Aussparung 5 so groß ist, daß aufzutragende Lotpaste 6 über die Anschlußfläche hinaus aufgetragen werden kann, um ein ausreichendes Lotvolumen für die Herstellung der Lötverbindung erhalten zu können. Dabei ist vorgesehen, daß die Aussparung flächenmäßig mindestens etwa doppelt so groß wie die Anschlußfläche ist. Eine obere Grenze der Aussparung ergibt sich durch das Rastermaß benachbarter Anschlußflächen bzw. der Bauelementanschlüsse und die Forderung, daß benachbarte Anschlußbereiche durch ein Lotresist voneinander getrennt werden müssen. Weiterhin erfindungswesentlich ist, daß die Anschlußfläche 3 bzw. 8 breiter ist als der an sie anschließende Verbindungsbereich 2 bzw. 9. Die Fläche der Aussparung wird in der anhand von Fig. 7 beschriebenen Weise ermittelt.

Nach dem Lotpastenauftrag, der gemäß Fig. 1 die Anschlußfläche 3 vollständig abdeckt, wobei jedoch eine Abdeckung des größten Teils der Anschlußfläche ausreichend ist, kann die Lotpaste zur Bildung eines

3

EP 0 618 757 A1

massiven Lotdepots 7 umgeschmolzen werden, Fig. 1c). Beim Umschmelzen reduziert sich das Volumen der Lotpaste etwa auf die Hälfte. Der Auftrag der Lotpaste selbst ist unkritisch und kann beispielsweises mit Hilfe eines Druckverfahrens oder eines Dispensers oder mit einem Rakel direkt auf die Leiterplatte erfolgen.

Unabhängig von den Verarbeitungsverfahren der Lotpaste bestimmt die notwendige Lotmenge für die Lötverbindung und die gewünschte Steighöhe des massiven Lots die Menge der aufzutragenden Lotpaste und die Fläche der Aussparung insbesondere in Bezug auf die Fläche der Anschlußfläche.

In Fig. 1 zieht sich die Lotpaste 6 beim Aufschmelzen auf die Anschlußfläche 3 zusammen, wobei sich das Volumen etwa auf die Hälfte reduziert, aber insgesamt das massive Lot höher ist als die zuvor aufgetragene Lotpaste. Beim Aufschmelzen wird die Erkenntnis ausgenutzt, daß sich aufgeschmolzenes Lot zu einer möglichst kugelförmien Gestalt auf der größten bzw. breitesten leitfähigen Fläche zusammenziehen will. Durch die Geometrie der Anschlußfläche im Vergleich zu den Verbindungsbereichen ergibt sich somit beim Aufschmelzen ein Zusammenziehen des Lots im wesentlichen auf die Anschlußfläche hin.

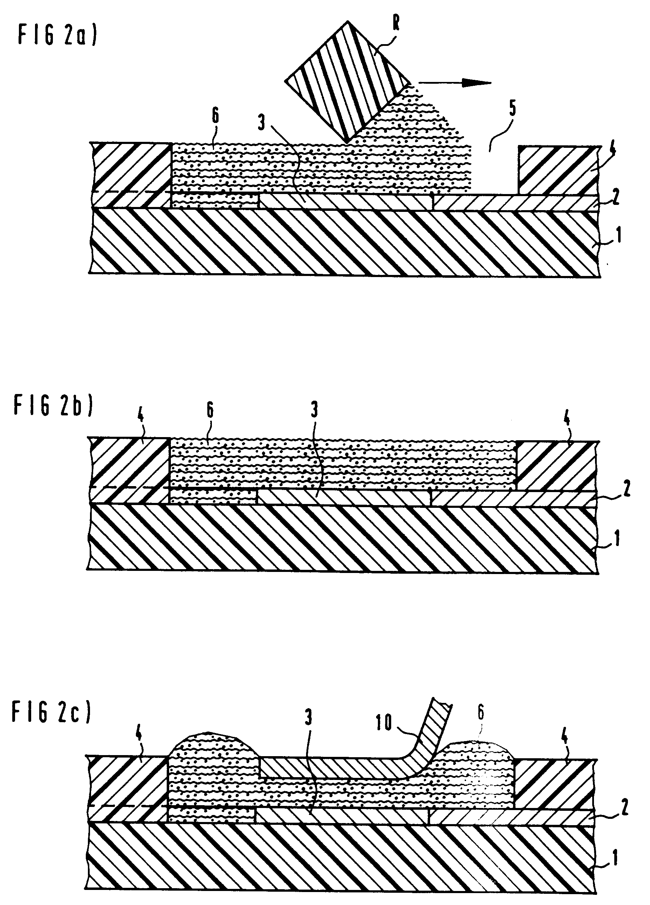

Gemäß Fig. 2 ist ein Bestückungsverfahren für eine Leiterplattenanordnung vorgesehen, bei dem es genügt, die aufzutragende Lotpaste mit einem Rakel R in die Aussparungen aufzutragen, so daß die aufwendigeren Methoden des Druckverfahrens oder z. B. mit einem Dispenser nicht erforderlich sind. Auch ist es bei diesem erfindungsgemäßen Verfahren nicht erforderlich, daß die Lotpaste über die Oberfläche des Lotresists hinausragt. In das gem. Fig. 2b) gebildete Lotpastenreservoir wird der Anschluß 10 eines Bauelements gesetzt, der sich dabei etwas in die Lotpaste eingrabt und geringfügig mechanisch in der Vertiefung der Aussparung einrastet. Bei dem anschließenden Reflowvorgang sammelt sich die aufgeschmolzene Lotpaste zu einem massiven Lot auf der Anschlußflache 3 und stellt eine sichere Lötverbindung zum Anschluß 10 des Bauelements her. Zu bemerken ist, daß Fig. 2 einen Schnitt durch die Anordnung gem. Fig. 1a) entlang der Linie B-B darstellt.

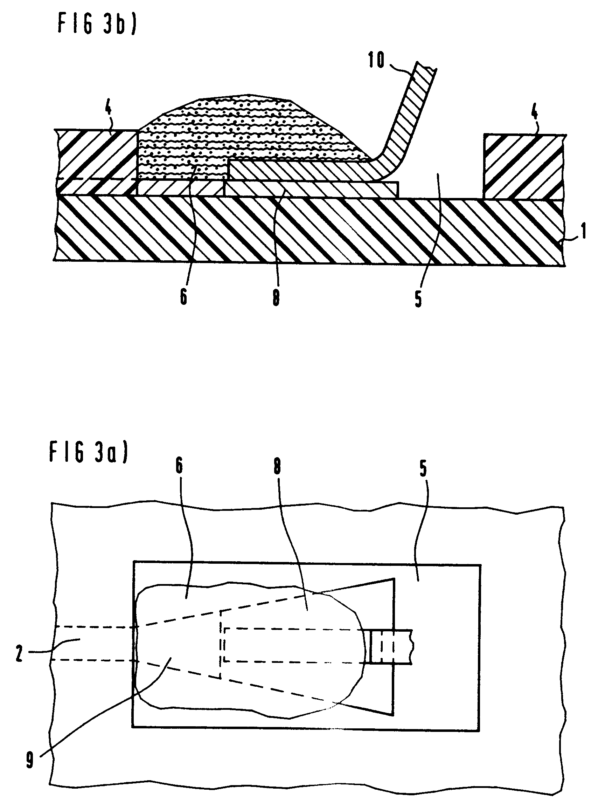

Gem. Fig. 3 ist die Anschlußfläche 8 trapezförmig ausgebildet und ein einseitiger Verbindungsbereich 9 schließt sich ohne Abstufung an und geht danach in einen streifenförmigen Verbindungsbereich 2 über. Das Ausführungsbeispiel zeigt den Fall, daß ein Anschluß 10 eines Bauelements vor dem Lotpastenauftrag in die Nähe oder in Kontakt mit der Anschlußfläche 8 gebracht wird. Der Anschluß liegt dabei vollständig in der Aussparung des Lötstopresists 4 und ist somit relativ gut fixiert. Durch eine in der SMD-Technik übliche Klebetechnik für das Bauelement kann die Fixierung bzw. Befestigung des Anschlusses 10 bezüglich der Anschlußfläche 8 noch weiter erhöht werden.

Nach dem Bestücken wird Lotpaste 6 in den von außen problemlos zugänglichen Teil der Aussparung 5 appliziert, z. B. mit einem Dosiergerät. Die Menge der Lotpaste bestimmt sich nach der Menge des gewünschten Massivlots und dessen Steighöhe. Beim Aufschmelzen der Lotpaste 6 sammelt sich das flüssige Lot geometriebedingt auf der Anschlußfläche 8 bzw. dem Anschluß 10 des Bauelements.

Der Vorteil dieses Verfahrens besteht darin, daß nur die besonders schwierig zu verlötenden Bauelemente mit engem Raster oder mit vielpoligen Anschlüssen auf diese Weise auf der Leiterplatte plaziert und verlötet werden müssen, während alle anderen Bauelemente in üblicher Lotpastentechnik verarbeitet werden können.

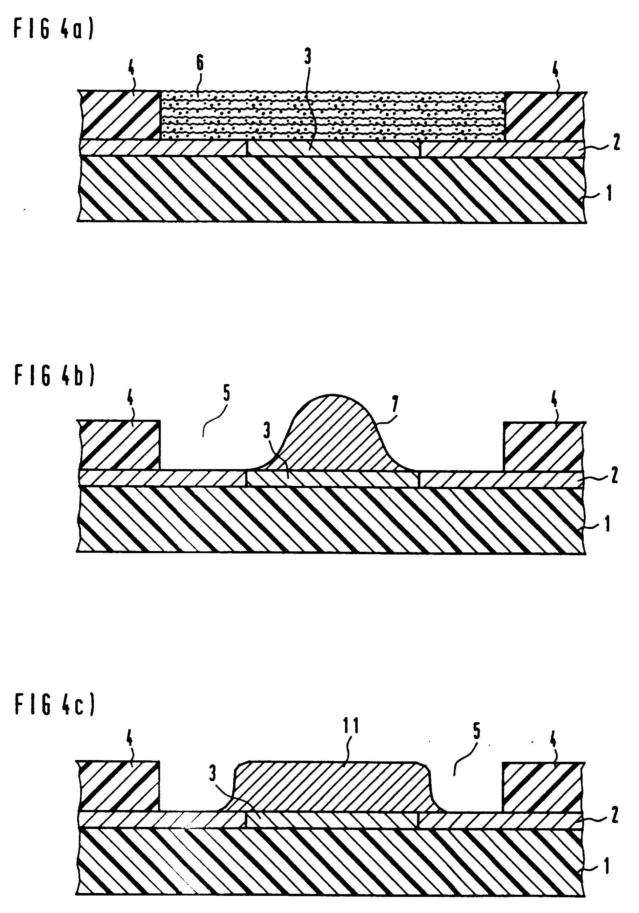

Fig. 4 zeigt im Unterschied zur Fig. 1 einen Querschnitt durch einen Anschlußbereich, bei dem die Lotpaste beispielsweise mit einem Rakel R gemäß Fig. 2 aufgetragen ist und danach die Lotpaste 6 zu einem massiven Lot 7 umgeschmolzen wurde, Fig. 4b). In einem nachfolgendem Schritt ist es möglich, unter nochmaligem Erhitzen der Anschlußstelle unter gleichzeitiger Ausübung eines flächenmäßigen Drucks in Richtung auf das Substrat der Leiterplatte eine bündige Oberfläche des Lotdepots 11 mit der Oberfläche des Lotresists zu erhalten, Fig. 4c). Dabei dehnt sich das Massivlot 11 über die Anschlußfläche hinaus auf die anschließenden Verbindungsbereiche hin aus. Nach dem anschließenden Bestücken mit dem Bauelement versucht das flachgedrückte Lotdepot 11 wieder eine möglichst kugelförmige Gestalt anzunehmen und verändert dabei die Lothöhe so, daß eine sichere Lotverbindung zwischen der Anschlußfläche 3 und dem Anschluß 10 des Bauelements hergestellt wird.

Alternativ zu dem Verfahren gemäß Figur 4 kann bereits nach dem Auftragen der Lotpaste gem. Fig. 4a) die Aussparung mit einer Platte verschlossen werden und die Lotpaste aufgeschmolzen werden. Nach dem darauffolgenden Abkühlen des Lots erhält man eine Anordnung gem. Fig. 4c).

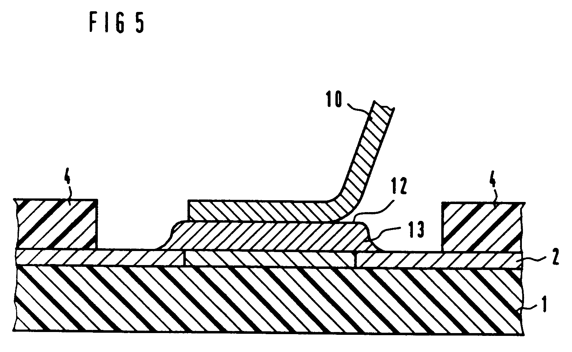

Gemäß Fig. 5 wird ein massives Lotdepot 13 mit flacher Oberfläche 12, die tiefer liegt als die Oberfläche des Lotresists 4, dadurch hergestellt, daß der Druck auf das Lot mit Hilfe einer Platte ausgeübt wird, die mit einem elastischen Material, z. B. Silikonkautschuk beschichtet ist. Bei einer derartigen Anordnung könnnen der oder die Anschlüsse eines Bauelements in die so entstehende Vertiefung der Aussparung quasi einrasten und eine zusätzliche Sicherheit für den Bestückvorgang bieten.

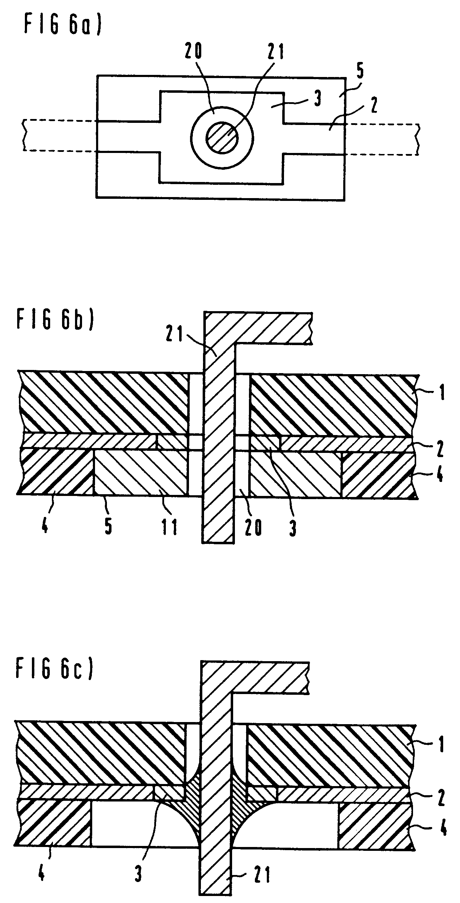

Gem. Fig. 6 wird eine bestückte Leiterplatte mit bedrahteten Bauelementen hrgestellt, bei denen zunächst in der zuvor beschriebenen Weise ein Lotdepot in der Aussparung 5 gebildet wird. Das Aufbringen des Lotdepots unterscheidet sich dabei nicht von dem Aufbringen eines Lotdepots für oberflächenmontierbare Bauelemente bzw. SMD-Bauelemente. Anschließend wird ein Loch 20 in das Lotdepot gebohrt, in das der Drahtanschluß 21 des Bauelements eingeführt wird. Durch die Geometrie des Anschlußbereiches, insbesondere der Anschlußfläche 3 sammelt sich das Lot beim anschließenden Reflowprozeß im Anschlußbereich 3 und überbrückt dabei den Spalt 20 zwischen dem Drahtanschluß 21 und der Anschlußfläche 3.

Anhand von Fig. 7 wird nun die Ermittlung der Aussparung des Lotresistbereichs beschrieben. Fig. 7 zeigt einen Querschnitt entland der Linie B-B, wie sie in Fig. 1 dargestellt ist.

Wesentliches Kriterium für die Bestimmung der Fläche der Aussparung 5 des Lotresistbereichs 4 ist die Aufschmelzhöhe der Lotpaste, da diese für eine gute Lötung ausschlaggebend ist. Dabei ist angenommen, daß in der zuvorbeschriebenen Weise eine Aussparung zunächst mit Lotpaste 6 vorgegebener Körnung gefüllt wird. Typischerweise wird eine Lotpaste mit feiner Körnung, d.h. mit Kugeldurchmessern von 25 bis 50 $\mu$m gewählt. Je nach der Art der Auftragung der Lotpaste ist ein unterschiedlicher Lotfüllungsgrad zu berücksichtigen. Wird beispielsweise die Lotpaste direkt durch Rakeln auf dem Lotresist 4 in die Aussparung 5 appliziert, dann ergibt sich ein Lotfüllungsgrad von etwa 70 %. Unter Lotfüllungsgrad ist dabei das Verhältnis der tatsächlichen Anzahl Lotkugeln pro Volumeneinheit zur theoretisch möglichen Anzahl Lotkugeln pro Volumeneinheit zu verstehen.

Nach dem Aufschmelzen der Lotpaste ergibt sich gemäß Fig. 7b ein massiver Lotkegel 7, der aufgrund der physikalischen Gegebenheiten im wesentlichen über dem leitfähigen Anschlußbereich 3 vorhanden ist. Dieser Lotkegel 7 hat die Lotkegelhöhe $h_L$. Die Lotkegelhöhe ist dabei so zu bemessen, daß ein in die Aussparung gebrachter Anschluß eines Bauelements 30 auch dann noch sicher verlötet wird, wenn dieser Anschluß eine zulässige Verbiegung aufweist. Das bedeutet, daß auch bei Bauteilen, die mittels Klebepunkten auf der Leiterplatte fixiert sind und deren Anschlüsse somit einen Mindestabstand zum leitfähigen Anschlußbereich 3 bzw. zum Lotresist 4 haben, die Lotkegelhöhe $h_L$ die zulässigen Toleranzen noch soweit berücksichtigt und kompensiert, daß eine gute und zuverlässige Lötverbindung zustande kommt. Bei einer zulässigen Verbiegung der Anschlüsse eines integrierten Schaltkreises von etwa 100 $\mu$m und einer Höhe $h_R$ des Lotresists von etwa 60 $\mu$m ist deshalb eine Lotkegelhöhe $h_L$ von mindestens 160 $\mu$m erforderlich. Es leuchtet ein, daß der Lotfüllungsgrad der Aussparung 5 von der gewählten Körnung der Lotpaste beeinflußt wird.

Die Lotkegelhöhe ist weiterhin vom Verhältnis der Fläche der Aussparung 5 des Lotresists zur Fläche der leitfähigen Bereiche, insbesondere des leitfähigen Anschlußbereichs 3 abhängig. Eine große Aussparung mit kleiner Anschlußfläche 3 bedingt eine große Lotkegelhöhe. Eine Verkleinerung der Fläche der Aussparung oder eine Vergrößerung der Fläche des Anschlußbereiches 3 bedeutet eine Verminderung der Lotkegelhöhe des massiven Lotkegels 7. Typisch werden Lotkegelhöhen bis 300 $\mu$m gewählt.

Bei einer vorgegebenen Höhe $h_A$ der leitfähigen Bereiche 2 bzw. 3 und einer vorgegebenen Höhe $h_R$ des Lotresists 4, einer gegebenen Geometrie der leitfähigen Bereiche 2 und 3, einem gegebenen Lotfüllungsgrad sowie der erforderlichen Lotkegelhöhe läßt sich bei einer Musteranordnung in wenigen einfachen Versuchen eine optimierte Fläche der Aussparung 5 ermitteln. Das Volumen $V_{LGM}$ der bei dem angenommenen Lotfüllungsgrad 6 in die Aussparung eingebrachten Lotpaste bezogen auf das Produkt aus der in der Aussparung 5 liegenden Fläche $A_{2,3M}$ der leitfähigen Bereiche 2 und 3 sowie der Höhe $h_{LM}$ des Lotkegels ergibt eine konstante, die für die Bestimmung der Fläche der Aussparung 5 bei anderer Parameterwahl verwendet wird:

$$\frac{V_{LGM}}{A_{2,3M} \cdot h_{LM}} = const.$$

In der Praxis wird im wesentlichen aus der Breite und der Länge eines zu verlötenden typischen Bauelementanschlusses die Geometrie des leitfähigen Anschlußbereichs 3 auf der Leiterplatte festgelegt bzw. vorgegeben. Dieser Anschlußbereich 3 muß über Verbindungsbereiche 2 mit weiteren Schaltungsteilen in leitfähiger Verbindung stehen. Das Ausführungsbeispiel der Fig. 8 zeigt einen ovalen Anschlußbereich 3 und vier Verbindungsbereiche 2, von denen die Bereiche 2a bzw. 2b jeweils gleich ausgebildet sind. Anstelle von vier Verbindungsbereichen 2 kann auch nur ein einseitiger Anschluß der Anschlußfläche 3 vorgesehen sein. Es ist zweckmäßig, die Breite der Anschlußfläche 3 als mindestens doppelt so groß zu berücksichtigen, wie die Breite der Verbindungsleitungen 2, damit sich die Lotpaste beim Aufschmelzen sicher im wesentlichen auf der Anschlußfläche 3 sammelt. Damit ist gleichzeitig einfach zu gewährleisten, daß die Fläche des Anschlußbereiches 3 den wesentlichen Anteil der in der Aussparung liegenden Fläche

EP 0 618 757 A1

der leitfähigen Bereiche darstellt. Da die Fläche bzw. die Geometrie der Aussparung 5 in dem Lotresist 4 erst ermittelt werden soll, ist die vorgegebene Fläche der leitfähigen Bereiche 2 und 3 nur ein Näherungswert, der im Rahmen der durch die Aussparung 5 freigelegten Teile der leitfähigen Verbindungsbereiche 2 schwanken kann. Selbstverständlich kann diese Fläche aber nach der Ermittlung der Fläche der Aussparung noch korrigiert werden, bevor die Leiterplatte hergestellt wird.

Aus der gegebenen Fläche $A_{2,3}$ der leitfähigen Bereiche 2 und 3, der erforderlichen Lotkegelhöhe $h_L$ sowie der in der zuvor beschriebenen Weise aus einer Musteranordnung entwickelten Konstanten wird durch Multiplikation dieser Faktoren das bei dem erreichbaren Lotfüllungsgrad erforderliche Lotpastenvolumen $V_{LG}$ bestimmt. Dieses erforderliche Lotpastenvolumen vermehrt um das Volumen $V_{2,3}$ der leitfähigen Bereiche 2 und 3, wobei die Höhe $h_A$ dieser Bereiche vom Leiterplattenhersteller vorgegeben ist, ergibt das notwendige Gesamtvolumen V der Aussparung 5. Durch Division dieses Gesamtvolumens durch den Lötfüllungsgrad G und die Dicke $h_R$ des gegebenen Lotresists ergibt sich die Grundläche der Aussparung 5. Ausgedrückt durch eine Formel ergibt sich somit die Grundfläche der Aussparung 5 näherungsweise zu:

$$A_5 \approx \frac{V}{G \cdot h_R} = \frac{V_{LG} + V_{2,3}}{G \cdot h_R} = \frac{V_{LGM} \cdot h_L \cdot A_{2,3}}{A_{2,3M} \cdot h_{LM} \cdot G \cdot h_R} + \frac{A_{2,3} \cdot h_A}{G \cdot h_R},$$

mit

$A_5$     Fläche der Aussparung 5
$V$     Lotpastenvolumen und Volumen der Bereiche 2 und 3
$G$     Lotfüllungsgrad
$h_R$     Höhe des Lotresists 4
$h_A$     Höhe der leitfähigen Bereiche 2,3
$h_L$     Höhe des massiven Lotkegels 7
$V_{LG}$     Volumen der Lotpaste bei gegebenem Füllungsgrad G
$A_{2,3}$     Fläche der leitfähigen Bereiche 2 und 3
$M$     Index für konstante, festgelegte Werte.

Aus der festgelegten Grundfläche der Aussparung 5 im Lotresistbereich 4 kann die Geometrie der Aussparung vorzugsweise entsprechend der Geometrie des leitfähigen Anschlußbereichs 3 einfach festgelegt werden. Das bedeutet, daß sich bei dem in Fig. 8 gezeigten ovalförmigen Anschlußbereich 3 eine ebenfalls ovalförmige Aussparung 5 im Lotresistbereich 4 ergibt. Selbstverständlich ist die Geometrie der Aussparung nicht zwingend an die Geometrie des leitfähigen Anschlußbereichs 3 geknüpft. Ebenso können auch andere als ovalförmige Geometrien vorgesehen sein, beispielsweise kreisförmige oder rechteckförmige Geometrieverhältnisse.

Mit der zuvor beschriebenen Erfindung wird erreicht, daß sich auch bei Bauelementen mit vielen Anschlüssen und extrem feinen Rastermaßen optimierte Lötverbindungen selbst dann herstellen lassen, wenn die zugelassenen Toleranzen ausgeschöpft werden müssen und der Lotpastenauftrag direkt auf der Leiterplatte erfolgt.

**Patentansprüche**

**1.** Leiterplattenanordnung, bei der auf einem Substrat (1) leitfähige Verbindungsbereiche (2) für leitfähige Anschlußbereiche (3) und Lotresistbereiche (4) vorgesehen sind, die höher sind als die leitfähigen Verbindungsbereiche und die im Bereich eines Anschlußbereichs eine Aussparung (5) aufweisen, **dadurch gekennzeichnet,** daß sich die Fläche einer Aussparung (5) des Lotresists (4) aus etwa dem Volumen ($V_{2,3}$) der leitfähigen Verbindungs- und Anschlußbereiche (2, 3) sowie einem für die Lötung benötigten Volumen ($V_{LG}$) eines vorgegebenen Lotmaterials (6) ergibt, indem diese Volumina auf die Höhe ($h_R$) des Lotresistbereichs und auf einen vorgegebenen Lotfüllungsgrad (G) der Aussparung des Lotresists mit Lotmaterial bezogen sind, wobei das benötigte Volumen ($V_{LG}$) an Lotmaterial in Abhängigkeit von etwa der Fläche ($A_{2,3}$) der leitfähigen Verbindungs- und Anschlußbereiche (2, 3) und der vorgegebenen Höhe ($h_L$) eines massiven Lotkegels (7) vorgesehen ist.

**2.** Anordnung nach Anspruch 1, **dadurch gekennzeichnet,** daß die geometrischen Abmessungen der Fläche der Aussparung (5) des Lotresists denen der Fläche des Anschlußbereichs (3) entsprechen.

6

**3.** Anordnung nach Anspruch 1 oder 2,
**dadurch gekennzeichnet,** daß das benötigte Volumen ($V_{LG}$) an Lotmaterial (6) proportional zu etwa der Fläche ($A_{2,3}$) der leitfähigen Verbindungs- und Anschlußbereiche und zu der vorgegebenen Höhe des massiven Lotkegels gegeben ist.

**4.** Anordnung nach einem der Ansprüche 1 bis 3,
**dadurch gekennzeichnet,** daß der Anschlußbereich (3, 8) rechteckförmig und der zugeordnete angeschlossene Verbindungsbereich (2) stegförmig oder streifenförmig ausgebildet sind.

**5.** Anordnung nach einem der Ansprüche 1 bis 4,
**dadurch gekennzeichnet,** daß dem Anschlußbereich (3, 8) an zwei Seiten angeschlossene leitfähige Verbindungsbereiche (2) zugeordnet sind.

**6.** Anordnung nach einem der Ansprüche bis 3,
**dadurch gekennzeichnet,** daß der Anschlußbereich (8) trapezförmig ist.

**7.** Anordnung nach Anspruch 6,
**dadurch gekennzeichnet,** daß der an den trapezförmigen Anschlußbereich (8) angeschlossene leitfähige Verbindungsbereich (9) an diese im wesentlichen ohne Abstufung anschließt.

**8.** Verfahren zur Herstellung einer Leiterplatte mit leitfähigen Verbindungs- (2) und Anschlußbereichen (3) in einer Aussparung (5) eines Lotresists (4), das höher als die Höhe der leitfähigen Bereiche ist, **gekennzeichnet** durch folgende Schritte:
- ein für die Lötung benötigtes Volumen ($V_{LG}$) an Lotmaterial wird in Abhängigkeit von dem Produkt aus der vorgegebenen Fläche ($A_{2,3}$) des leitfähigen Verbindungs- und Anschlußbereichs (2, 3) in der Aussparung (5) des Lotresists und einer vorgegebenen Höhe ($h_L$) eines massiven Lotkegels (7) ermittelt,
- das Volumen an Lotmaterial und das Volumen ($V_{2,3}$) der leitfähigen Verbindungs- und Anschlußbereiche der Aussparung werden jeweils durch die Höhe ($h_R$) des Lotresists und einen gegebenen Lotfüllungsgrad (G) zur Ermittlung einer Grundfläche ($A_5$) der Aussparung (5) dividiert und
- die geometrischen Abmessungen der Aussparung (5) mit der ermittelten Grundfläche ($A_5$) werden festgelegt.

**9.** Verfahren nach Anspruch 8,
**dadurch gekennzeichnet,** daß das benötigte Volumen an Lotmaterial proportional zu etwa der Fläche der leitfähigen Verbindungs- und Anschlußbereiche in der Aussparung des Lotresists und der vorgegebenen Höhe des massiven Lotkegels gewählt wird.

**10.** Verfahren zur Herstellung einer bestückten Leiterplatte unter Verwendung einer Leiterplattenanordnung bzw. eines Verfahrens nach einem der Ansprüche 1 bis 9, wobei die Leiterplatte leitfähige Verbindungs- und Anschlußbereiche (2, 3) in einer Aussparung (5) eines Lotresists (4) aufweist, das höher ist als die Höhe der leitfähigen Bereiche, **gekennzeichnet** durch folgende Schritte:
- in der Aussparung (5) des Lotresists (4) wird Lotmaterial (6) aufgetragen, das den leitfähigen Anschlußbereich (3) und einen angrenzenden nichtleitfähigen Bereich der Aussparung zumindest teilweise bedeckt,
- ein Anschluß (10) eines Bauelements wird dem leitfähigen Anschlußbereich (3) zur Herstellung einer Lötverbindung zwischen dem Anschluß und dem leitfähigen Anschlußbereich zugeordnet,
- durch eine Temperaturbehandlung wird das Lotmaterial (6, 7) geschmolzen.

FIG 1a)

FIG 1b)

FIG 1c)

FIG 2a)

FIG 2b)

FIG 2c)

FIG 3b)

FIG 3a)

FIG 4a)

FIG 4b)

FIG 4c)

FIG 5

F I G 6 a )

F I G 6 b )

F I G 6 c )

Fig. 7a

Fig. 7b

Fig. 8

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int.Cl.5) |
|---|---|---|---|
| A | WO-A-90 07792 (MOTOROLA) <br> * Seite 4, Zeile 29 - Seite 5, Zeile 6 * <br> * Abbildungen * | 1-4,8-10 | H05K3/34 |
| D | & US-A-5 024 372 (ALTMAN ET AL.) <br> --- | | |
| A | EP-A-0 487 782 (SIEMENS AG) <br> * Spalte 2, Zeile 52 - Spalte 4, Zeile 24; Abbildungen * | 1-4,8-10 | |
| D | & US-A-5 172 853 (MAIWALD) <br> --- | | |
| P,X | WO-A-93 23981 (MASK TECHNOLOGY) <br> * Seite 4, Zeile 8 - Zeile 20 * <br> * Abbildungen * <br> --- | 1,2,8-10 | |
| A | EP-A-0 307 766 (SIEMENS AG) <br> ----- | | |

| | |
|---|---|
| | **RECHERCHIERTE SACHGEBIETE (Int.Cl.5)** |
| | H05K <br> H01L |

Der vorliegende Recherchenbericht wurde für alle Patentansprüche erstellt

| Recherchenort | Abschlußdatum der Recherche | Prüfer |
|---|---|---|
| DEN HAAG | 6. Juni 1994 | Mes, L |